**Europäisches Patentamt**

**European Patent Office**

**Office européen des brevets**

(11) Veröffentlichungsnummer : **0 161 483**
**B1**

(12) **EUROPÄISCHE PATENTSCHRIFT**

(45) Veröffentlichungstag der Patentschrift :
07.09.88

(51) Int. Cl.⁴ : **G 01 N 24/08**

(21) Anmeldenummer : 85104327.3

(22) Anmeldetag : 10.04.85

(54) Verfahren zum Anregen einer Probe für die NMR-Tomographie.

(30) Priorität : 18.04.84 DE 3414635

(43) Veröffentlichungstag der Anmeldung :
21.11.85 Patentblatt 85/47

(45) Bekanntmachung des Hinweises auf die Patenterteilung : 07.09.88 Patentblatt 88/36

(84) Benannte Vertragsstaaten :
FR GB NL

(56) Entgegenhaltungen :
EP-A- 0 088 970
DE-A- 2 936 465
US-A- 4 115 730
MEDICAL PHYSICS, Band 10, Nr. 5, September-Oktober 1983, Seiten 642-645, American Association of Physics and Medicin, New York, US; N.J. SCHNEIDERS et al.: "Accurate T2 NMR images"
E. FUKUSHIMA et al: "Experimental pulse NMR", 1981, Seiten 25-35, Addison-Wesley Publishing Co., Inc., Reading, Massachusetts, US

(73) Patentinhaber : Bruker Medizintechnik GmbH
Silberstreifen
D-7512 Rheinstetten-Forchheim (DE)

(72) Erfinder : Ströbel, Bernhard
Esterwaystrasse 67
D-7517 Waldbronn 3 (DE)
Erfinder : Ratzel, Dieter
Buchenweg 31
D-7512 Rheinstetten 4 (DE)

(74) Vertreter : Patentanwälte Kohler - Schwindling - Späth
Hohentwielstrasse 41
D-7000 Stuttgart 1 (DE)

## Beschreibung

Die Erfindung betrifft ein Verfahren zum Anregen einer Probe für die NMR-Tomographie, bei dem die Probe außer einem homogenen Magnetfeld einem Selektionsgradienten ausgesetzt und mit einem 90°-Selektionsimpuls angeregt, danach der Selektionsgradient durch einen zeitlich begrenzten Phasenkodierungsgradienten und einen Lesegradienten ersetzt, wobei Selektionsgradient, Phasenkodierungsgradient und Lesegradient jeweils paarweise zueinander senkrecht stehen, und schließlich die Probe nach Beendigung des Phasenkodierungsgradienten bei herrschendem Lesegradienten mit einer Folge von 180°-Impulsen bestrahlt wird, wodurch meßbare Kerninduktionssignale in Form sogenannter Spinechos erzeugt werden.

Die Erzeugung und Messung von Kernresonanzsignalen unter dem Einfluß eines Phasenkodierungsgradienten und eines Lesegradienten führt durch Anwenden einer zweidimensionalen Fourier-Transformation zur Erzeugung von Querschnittsbildern, weshalb dieses Verfahren auch 2DFT genannt wird. Wie oben angegeben, ist es grundsätzlich denkbar, zur Erzeugung der Kerninduktionssignale die allgemein in der NMR-Spektrometrie verwendeten Spinecho-Impulsfolgen zu verwenden, wie insbesondere die Carr-Purcell-Impulsfolge oder die Carr-Purcell-Gill-Meiboom-Impulsfolge. Diese Impulsfolgen ermöglichen die Erzeugung einer Vielzahl von Echosignalen nach einer gemeinsamen Anregung, welche zur Verbesserung des Signal-Rausch-Verhältnisses aufaddiert oder aber zur Bestimmung der Spin-Spin-Relaxationszeit $T_2$ verwendet werden können. Es hat sich jedoch gezeigt, daß bei Anwendung der 2DFT-Methode die bisher bekannten Impulsfolgen nur beschränkt anwendbar sind, da mit wachsender Anzahl der Echos in zunehmendem Maße Artefakte in Form von Bildern auftreten, welche gegenüber dem ungestörten Bild an einer zur Richtung des Lesegradienten parallelen Achse gespiegelt sind. Derartige Artefakte werden im folgenden Spiegelbilder genannt.

Da andererseits beispielsweise eine genaue $T_2$-Bestimmung oder eine Analyse nach verschiedenen $T_2$-Beiträgen bei einer multiexponentiellen Spin-Spin-Relaxation nur mit Hilfe vieler Spinechos durchführbar ist, war das 2DFT-Verfahren für solche Untersuchungen, welche von großer Bedeutung in der diagnostischen Medizin sind, bisher nicht einsetzbar, obwohl es den Vorteil hat, schon bei relativ geringer Homogenität des Magnetfeldes gute Bilder zu liefern, so daß dieses Verfahren unter anderem für einfachere Anlagen aus dieser Sicht heraus besonders gut geeignet wäre.

Demgemäß liegt der Erfindung die Aufgabe zugrunde, das Verfahren der eingangs genannten Art so zu verbessern, daß bei der Anwendung von Spinecho-Impulsfolgen keine Spiegelbilder mehr entstehen.

Diese Aufgabe wird nach der Erfindung dadurch gelöst, daß die Phasenlage und damit die Drehrichtung der 180°-Impulse nach jeweils zwei Impulsen umgekehrt wird, so daß jeder Impuls der Folge einem Impuls gleicher und einem Impuls entgegengesetzter Drehrichtung zeitlich benachbart ist.

Die Erfindung besteht demnach in einer Modifikation sowohl der bekannten Carr-Purcell-Impulsfolge, bei welcher die Phasenlage der 180°-Impulse gleich der des vorangehenden 90°-Anregungspulses ist, als auch der bekannten Carr-Purcell-Gill-Meiboom-Impulsfolge, bei der die Phasenlage aller 180°-Impulse gegenüber dem 90°-Anregungspuls um 90° gedreht, jedoch innerhalb der Folge von 180°-Impulsen gleich ist. Durch die überraschend einfache Maßnahme, die Phasenlage innerhalb der Folge von 180°-Impulsen nach jedem zweiten Impuls umzukehren, werden trotz der Anwendung einer Spinecho-Impulsfolge mittels der 2DFT-Methode spiegelfreie Bilder erzielt.

Die Erfindung wird im folgenden anhand der in der Zeichnung dargestellten Diagramme näher beschrieben und erläutert. Es zeigen

Fig. 1 ein Zeitdiagramm der Gradientenfelder und Signale bei einem herkömmlichen 2DFT-Verfahren unter Verwendung einer Carr-Purcell-Gill-Meiboom-Impulsfolge,

Fig. 2 Zeigerdiagramme zur Veranschaulichung der unter Verwendung des Verfahrens nach Fig. 1 in die X, Y-Ebene gedrehten Spinmomente,

Fig. 3 Zeigerdiagramme der in Fig. 2 dargestellten Spinmomente in der X, Z-Ebene,

Fig. 4 Zeigerdiagramme zur Erläuterung der Entstehung von Spiegelbildern und

Fig. 5 ein Schema zur Erläuterung der Kompensation von Fehlern im Drehwinkel der 180°-Impulse nach dem erfindungsgemäßen Verfahren.

Wie bekannt, wird bei der NMR-Tomographie eine zu untersuchende Probe, insbesondere ein menschlicher Körper oder Körperteil, in ein starkes homogenes Magnetfeld $B_0$ gebracht, dessen Richtung gewöhnlich die Z-Achse eines rechtwinkligen Koordinatensystems zugeordnet wird. Durch die Einwirkung dieses Magnetfeldes sind die magnetischen Spinmomente der Atomkerne in der Probe normalerweise, d. h. ohne eine zusätzliche äußere Einwirkung, in Z-Richtung ausgerichtet. Die zur Herstellung eines Bildes benötigte Information kann jedoch nur aus den HF-Signalen gewonnen werden, welche von den in der X, Y-Ebene um die Z-Richtung rotierenden, zu Z senkrechten Komponenten der Spinmomente erzeugt werden. Diese Signale werden Kerninduktionssignale genannt. Daher müssen die Spinmomente in den abzubildenden Bereichen der Probe durch Einstrahlen von Hochfrequenz in geeigneter Weise aus der Z-Richtung herausgedreht werden, vorzugsweise um 90° bis in die X, Y-Ebene.

Für die Abbildung eines Querschnitts der zu untersuchenden Probe müssen daher die Spinmomente innerhalb einer ausgewählten Scheibe der Probe möglichst vollständig in die X, Y-Ebene gedreht werden, wohingegen die Spinmomente außerhalb der Scheibe möglichst vollständig in der Z-Richtung ausgerichtet bleiben müssen. Dieser Vorgang wird selektive Anregung der Spinmomente genannt ; der Zeitabschnitt innerhalb eines tomographischen Verfahrens, in welchem die selektive Anregung erfolgt, wird Selektionsphase genannt.

Die in die X, Y-Ebene gedrehten Spinmomente werden beim 2DFT-Verfahren der dephasierenden Wirkung der als Phasenkodierungsgradient und als Lesegradient bezeichneten Gradientenfelder ausgesetzt. Da die zur Herstellung eines Bildes benötigte Information aus dem Einfluß dieser Dephasierung auf die zu beobachtenden Kerninduktionssignale gewonnen wird, muß die selektive Anregung so erfolgen, daß durch sie die anzuregenden Spinmomente möglichst weitgehend in Phase in die X, Y-Ebene gedreht werden, das heißt, daß sie ohne den Einfluß von Phasenkodierungsgradient oder Lesegradient möglichst gleichphasig um die Z-Richtung rotieren.

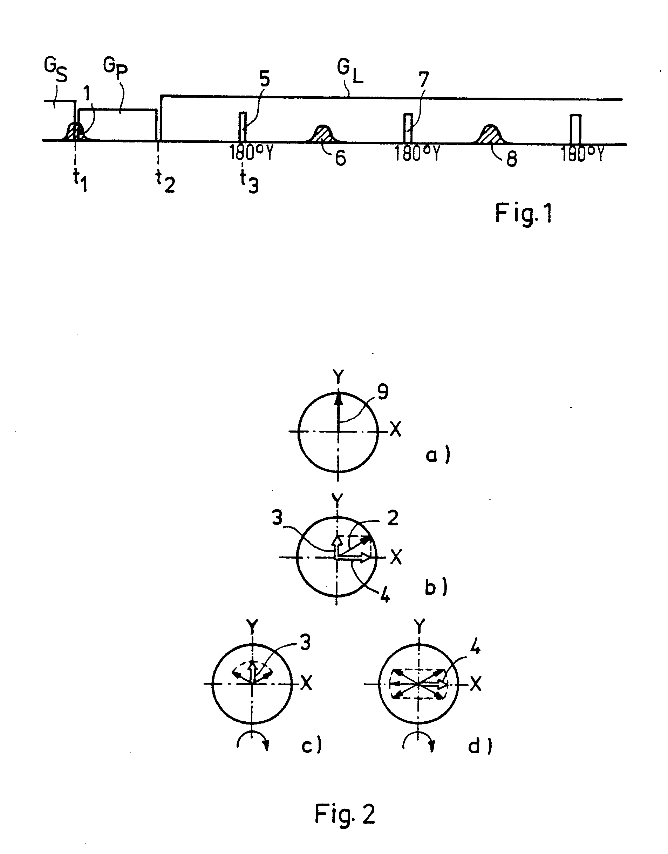

Ein bekanntes Verfahren zur selektiven Anregung, das diese Bedingung erfüllt, besteht darin, dem homogenen Magnetfeld $B_0$ ein magnetisches Gradientenfeld zu überlagern, das ebenfalls parallel zur Z-Richtung ausgerichtet ist, dessen Stärke sich aber längs einer Richtung, die senkrecht auf der für das Bild ausgewählten Querschnittsebene steht, ändert. Dieses Gradientenfeld wird Selektionsgradient genannt. Unter dem Einfluß der anliegenden Magnetfelder ändert sich die Larmorfrequenz der Spinmomente in der Probe längs der Richtung des Selektionsgradienten. (Die Richtung, in der sich die magnetische Feldstärke bei Vorhandensein eines Gradientenfeldes ändert, wird hier und im folgenden kurz als Richtung dieses Gradienten bezeichnet.) Durch Einstrahlen eines schmalbandigen HF-Impulses lassen sich daher die Spinmomente innerhalb einer zur Richtung des Selektionsgradienten senkrechten Scheibe der Probe, deren Dicke durch die Bandbreite des HF-Impulses gegeben ist, um einen Winkel $\alpha$ aus der Richtung der Z-Achse heraus, vorzugsweise bei entsprechender Dimensionierung des Impulses, um den Winkel 90° bis in die X, Y-Ebene drehen. Im folgenden wird ein Impuls, der die Spinmomente um den Winkel $\alpha$ dreht, als $\alpha$-Impuls bezeichnet. Nach Beendigung des selektiven 90°-Impulses wird nach dem bekannten Verfahren die Richtung des Selektionsgradienten umgekehrt, um so eine Rephasierung der während der Dauer des 90°-Impulses unter dem Einfluß des Selektionsgradienten dephasierten Spinmomente innerhalb der Scheibe zu bewirken. Eine weitere Möglichkeit der Rephasierung besteht in der Anwendung eines 180°-Impulses nach Beendigung des 90°-Impulses bei unverändert anstehendem Selektionsgradienten. In beiden Fällen wird zum Zeitpunkt der vollständig erfolgten Rephasierung der Selektionsgradient ausgeschaltet. Dieser Zeitpunkt stellt das Ende der Selektionsphase dar ; er ist in dem Diagramm nach Fig. 1 mit $t_1$ gekennzeichnet. Die vollständige Rephasierung der Spinmomente zum Zeitpunkt $t_1$ ist mit dem Auftreten eines Kerninduktionssignals in Form eines sogenannten Spinechos 1 verbunden.

Die Selektionsphase ist jedoch nicht Gegenstand dieser Erfindung. Daher ist sie auf dem Diagramm nach Fig. 1 nicht vollständig dargestellt. Im folgenden wird lediglich angenommen, daß während der Selektionsphase in der vorstehend beschriebenen oder in einer anderen Weise die Spinmomente innerhalb der abzubildenden Scheibe möglichst vollständig und so in die X, Y-Ebene gedreht worden sind, daß sie zum Zeitpunkt $t_1$ in Phase um die Z-Richtung rotieren.

Die Phasenlage der Spinmomente innerhalb der X, Y-Ebene wird, wie allgemein üblich, mit Hilfe eines mit der Larmorfrequenz von $B_0$ um die Richtung der Z-Achse rotierenden Koordinatensystems beschrieben. Die Richtungen in diesem System werden im folgenden mit X, Y und Z bezeichnet, wobei die Z-Richtung feststeht, und die X- und Y-Richtungen in der X, Y-Ebene rotieren. (In einem ruhenden Koordinatensystem stellen die Richtungen X und Y Phasenlagen einer mit Larmorfrequenz um die Richtung der Z-Achse erfolgenden Präzessionsbewegung dar.) Die X-Richtung sei im folgenden durch die Annahme festgelegt, daß die selektive Anregung durch einen 90°, X-Impuls stattgefunden hat. Hierunter soll ein Impuls verstanden werden, der die Spinmomente um 90° um die Richtung von X dreht, so daß sie zur Zeit $t_1$ in die Y-Richtung des rotierenden Koordinatensystems deuten. Diese Phasenlage der Spinmomente zur Zeit $t_1$ ist in Fig. 2a unter 9 dargestellt.

Im Zeitpunkt $t_1$ wird der Phasenkodierungsgradient $G_P$ eingeschaltet, der eine dephasierende Wirkung derart hat, daß an seinem Ende im Zeitpunkt $t_2$ die Phasenlage bestimmter Spinmomente z. B. in die Richtung des Pfeiles 2 gedreht worden ist (Fig. 2b). Das 2DFT-Verfahren beruht darauf, daß mittels Variation von Dauer oder Intensität des Phasenkodierungsgradienten $G_P$ unterschiedliche Phasenlagen eingestellt werden, welche unterschiedliche Intensitäten der unter dem Lesegradienten $G_L$ gemessenen Signale ergeben, die nach entsprechender Verarbeitung der Signale die bildliche Darstellung einer Querschnittsebene der Probe ermöglichen.

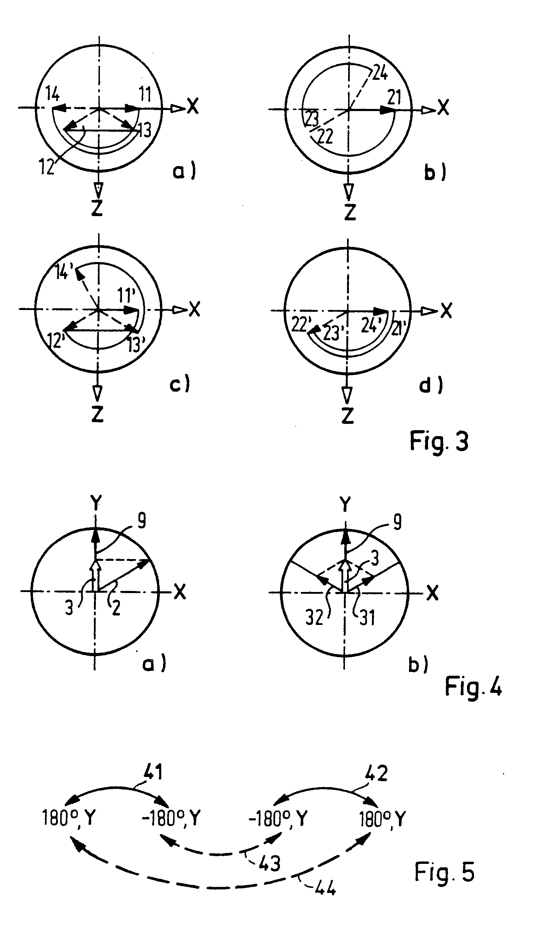

Wie in Fig. 2b dargestellt, kann das Spinmoment 2 in eine Y-Komponente 3 und in eine X-Komponente 4 zerlegt werden. Bezüglich dieser Komponenten tritt bis zur Zeit $t_3$ des ersten 180°-Impulses eine Dephasierung der Spinmomente ein, welche auf die Variation des Magnetfeldes unter dem im Zeitpunkt $t_2$ eingeschalteten Lesegradienten $G_L$ und auch auf Feld-Inhomogenitäten zurückzuführen ist. Die Dephasierung für die Y- und die X-Komponente im Zeitpunkt $t_3$ ist in Fig. 2c bzw. 2d dargestellt. Der 180°-Impuls im Zeitpunkt $t_3$ dient in herkömmlicher Weise dazu, die Dephasierung rückgängig zu machen, so daß es eine gewisse Zeit nach dem 180°-Impuls 5 zur Erzeugung eines Echosignals 6 kommt. Bei dem dargestellten Ausführungsbeispiel sei der Impuls 5 ein 180°, Y-Impuls, welcher eine Drehung der Spinmomente um 180° um die Y-Achse bewirkt. Um diese Drehung zu veranschaulichen, sind die Spinmomente der Fig. 2c und 2d in den Fig. 3a und 3b in ihrer Projektion in die X, Z-Ebene dargestellt. Auf die Y-Komponente 3 von Fig. 2b hat der um die Y-Achse drehende 180°-Impuls die gleiche Wirkung wie die Impulse einer Carr-Purcell-Gill-Meiboom-Impulsfolge. Für diese Impulsfolge ist charakteristisch, daß nicht nur die Phasenfehler ausgeglichen werden, die auf unterschiedliche Larmorfrequenzen infolge von Magnetfeld-Inhomogenitäten zurückzuführen sind, sondern daß im Verlauf der Impulsfolge auch die Fehler kompensiert werden, welche dadurch entstehen, daß aufgrund mangelhafter Justierung der Pulslänge oder einer örtlichen Variation der $H_1$-Feldstärke bestimmte Spinmomente durch einen « 180°-Impuls » tatsächlich um einen kleineren oder größeren Winkel als 180° gedreht werden. Wie diese Kompensation stattfindet, zeigt Fig. 3a. Die zu geringe Drehung von 11 nach 12 durch den Impuls 5 wird durch die Verschiebung des Ausgangspunktes in 13 kompensiert, so daß nach dem nächsten 180°-Impuls 7 beim Echosignal 8 (Fig. 1) das Spinmoment wieder in der X, Y-Ebene liegt (Pos. 14). Anders verhält es sich bei der X-Komponente 4 von Fig. 2b des Spinmomentes gemäß Fig. 3b. Hier schließt sich an die Drehung von der Pos. 21 zur Pos. 22 die ebenfalls zu kleine Drehung von der Pos. 23 zur Pos. 24 an, wodurch sich der Phasenfehler vergrößert. Die Folge davon ist, daß bei Anwendung einer Carr-Purcell-Gill-Meiboom-Impulsfolge nach Fig. 1 der aus der X-Komponente hervorgehende Signalanteil binnen kurzem völlig verschwindet und nur der aus der Y-Komponente hervorgehende Signalanteil übrig bleibt. Würde eine um die X-Achse drehende Impulsfolge verwendet, so träte die Kompensation bezüglich des aus der X-Komponente hervorgehenden Signalanteils auf, während der aus der Y-Komponente hervorgehende Signalanteil verschwinden würde. Eine weitere, aus der NMR-Spektroskopie bekannte Variante der Carr-Purcell-Impulsfolge besteht in einer Umkehrung der Phasenlage der 180°-Impulse nach jedem Impuls. Wird eine solche einfach alternierende, um die Y-Achse drehende Impulsfolge verwendet, so tritt nach Fig. 3c, Pos. 11' bis 14' ein Verschwinden des aus der Y-Komponente hervorgehenden Signalanteils und nach Fig. 3d, Pos. 21' bis 24' eine Kompensation für den aus der X-Komponente hervorgehenden Signalanteil ein. Das Gegenteil ist wiederum der Fall für eine einfach alternierende, um die X-Achse drehende Impulsfolge.

Bei dem in Fig. 1 dargestellten, dem Stand der Technik entsprechenden Ausführungsbeispiel einer Spinecho-Impulsfolge (Carr-Purcell-Gill-Meiboom-Impulsfolge) sei daher angenommen, daß aufgrund der stets vorhandenen Abweichungen des Drehwinkels von 180° der aus der X-Komponente hervorgehende Signalanteil im Verlauf einiger Echos verschwindet. Dadurch tritt ein Informationsverlust ein, und der allein verbleibende, aus der Y-Komponente hervorgegangene Signalanteil wird so gedeutet, als ob zum Zeitpunkt $t_2$ anstelle des Spinmoments 2 mit der richtig kodierten Phasenlage (Fig. 4a) zwei aus der ursprünglichen Phasenlage 1 in Y-Richtung durch gegensinnige Phasendrehung unter dem Phasenkodierungsgradienten hervorgegangene Spinmomente 31, 32 von jeweils der halben Stärke von 2 vorhanden wären, deren Resultierende die Y-Komponente 3 ist (Fig. 4b). Die Komponenten 31, 32 der Spinmomente ergeben die Spiegelbilder, welche das tatsächliche Querschnittsbild völlig verfälschen und daher bisher die Anwendung von Spinecho-Impulsfolgen bei der 2DFT-Technik unmöglich machten. In gleicher Weise treten Spiegelbilder auch bei den anderen bekannten Spinecho-Impulsfolgen auf, bei denen die Phasenlage der 180°-Impulse gleichbleibt oder einfach alterniert.

Die vorstehend geschilderten Zusammenhänge waren nicht bekannt und auch keineswegs offensichtlich. Es bedurfte vielmehr sehr intensiver Untersuchungen, um zu einer Erklärung für die Spiegelbilder zu kommen. Aufgrund der vorstehend dargelegten Deutung der Entstehung der Spiegelbilder läßt sich nun auch ein Verfahren angeben, wie diese Spiegelbilder vermeidbar sind. Dieses Verfahren besteht darin, die Phasenlage der 180°-Impulse nach jedem zweiten Impuls umzukehren (doppelt alternierende Impulsfolge). Bei einer doppelt alternierenden Impulsfolge (Beispiele : +180°, Y... —180°, Y... —180°, Y... +180°, Y... etc. oder : +180°, Y... +180°, Y... —180°, Y... —180°, Y... etc.) ist jedem Impuls zeitlich sowohl ein gleichartiger Impuls, als auch ein Impuls mit umgekehrtem Vorzeichen benachbart. Dadurch erfolgt, unabhängig von der Achse, auf welche die 180°-Impulse wirken, nach jeweils vier aufeinanderfolgenden Impulsen eine vollständige Kompensation der durch Abweichungen vom Drehwinkel 180° hervorgerufenen Fehler, unabhängig von der zum Zeitpunkt $t_2$ vorhandenen, durch den Phasenkodierungsgradienten bewirkten Phasenlage der Spinmomente. Dies ist in Fig. 5 am Beispiel der doppelt alternierenden Pulsfolge +180°, Y... —180°, Y... —180°, Y... +180°, Y... etc. dargestellt. Dabei symbolisieren die durchgezogenen Bögen 41 und 42 die Kompensation bezüglich des aus der X-Komponente hervorgegangenen Signalanteils durch Impulspaare mit verschiedenem Vorzeichen, und die gestrichelten Bögen 43 und 44 die Kompensation bezüglich des aus der Y-Komponente hervorgegangenen Signalanteils durch Impulspaare mit gleichem Vorzeichen.

Der Fig. 1 und der Beschreibung der Erfindung ist aus Gründen der Übersichtlichkeit eine Ausführungsform des 2DFT-Verfahrens zugrundegelegt, bei der die drei Gradientenfelder $G_S$, $G_P$ und $G_L$ nacheinander, jedoch unmittelbar aneinander anschließend erzeugt werden. Es sind jedoch auch andere Ausführungsformen des 2DFT-Verfahrens bekannt und möglich. Insbesondere können der Phasenkodierungsgradient $G_P$ und der

Lesegradient G$_L$ gleichzeitig erzeugt werden, oder es kann wenigstens einer dieser beiden Gradienten schon zu einem Zeitpunkt eingeschaltet werden, zu dem noch keine vollständige Rephasierung bezüglich des Selektionsgradienten G$_S$ erfolgt ist und daher der Selektionsgradient noch anliegt. In diesem letzteren Falle wird das Spinecho 1 nicht oder nur abgeschwächt beobachtet. Das erfindungsgemäße Verfahren der Verwendung doppelt alternierender Pulssequenzen ist jedoch unabhängig von der jeweiligen gewählten Ausführungsform des 2DFT-Verfahrens.

### Patentanspruch

Verfahren zum Anregen einer Probe für die NMR-Tomographie, bei dem die Probe außer einem homogenen Magnetfeld einem Selektionsgradienten ausgesetzt und mit einem 90°-Selektionsimpuls angeregt, danach der Selektionsgradient durch einen zeitlich begrenzten Phasenkodierungsgradienten und einen Lesegradienten ersetzt, wobei Selektionsgradient, Phasenkodierungsgradient und Lesegradient jeweils paarweise zueinander senkrecht stehen, und schließlich die Probe nach Beendigung des Phasenkodierungsgradienten bei herrschendem Lesegradienten mit einer Folge von 180°-Impulsen bestrahlt wird, wodurch mehrere Kerninduktionssignale in Form sogenannter Spinechos erzeugt werden, dadurch gekennzeichnet, daß die Phasenlage und damit die Drehrichtung der 180°-Impulse nach jeweils zwei Impulsen umgekehrt wird, so daß jeder Impuls der Folge einem Impuls gleicher und einem Impuls entgegengesetzter Drehrichtung zeitlich benachbart ist.

### Claim

A method of stimulating a specimen for NMR tomography, in which the specimen is exposed not only to an homogeneous magnetic field but to a selection gradient and is stimulated with a 90° selection pulse, after which the selection gradient is replaced by a time-limited phase coding gradient and a reading gradient, selection gradient, phase coding gradient and reading gradient being in each case paired and perpendicular to one another, the specimen, upon completion of the phase coding gradient and while the reading gradient is prevailing, being finally irradiated with a sequence of 180° pulses so that a plurality of nuclear magnetic resonance (NMR) signals in the form of so-called spin echoes are generated, characterised in that the phase situation and thus the direction of rotation of the 180° pulses is reversed after every two pulses so that each pulse in the sequence is with regard to time adjacent a pulse of the same and a pulse of opposite direction of rotation.

### Revendication

Procédé pour exciter un échantillon ou objet à examiner par tomographie R.M.N., selon lequel on expose l'objet à un champ magnétique homogène et en plus à un gradient de sélection et on l'excite par une impulsion de sélection de 90°, on remplace ensuite le gradient de sélection par un gradient de codage de phase limité dans le temps et un gradient de lecture, le gradient de sélection, le gradient de codage de phase et le gradient de lecture étant perpendiculaires par paire, et on irradie enfin l'objet, après avoir fait cesser le gradient de codage de phase et pendant que le gradient de lecture reste appliqué, avec une succession d'impulsions de 180°, ce qui engendre plusieurs signaux d'induction nucléaire sous forme de ce que l'on appelle des échos de spin, caractérisé en ce que la position de phase et par suite le sens de rotation des impulsions de 180° sont inversés chaque fois après deux impulsions, de sorte que chaque impulsion de la succession est voisine, dans le temps, d'une impulsion de même sens de rotation et d'une impulsion de sens de rotation inverse.

Fig. 1

Fig. 2

Fig. 3

Fig. 4

Fig. 5